Europäisches Patentamt

European Patent Office

Office européen des brevets

(19)

(11) EP 0 805 368 A1

(12) ## DEMANDE DE BREVET EUROPEEN

(43) Date de publication:
05.11.1997 Bulletin 1997/45

(51) Int Cl.$^6$: **G02B 27/09, H01S 3/25**

(21) Numéro de dépôt: **97400957.3**

(22) Date de dépôt: **29.04.1997**

(84) Etats contractants désignés:
DE GB

(30) Priorité: **30.04.1996 FR 9605425**

(71) Demandeur: **THOMSON-CSF**
**75008 Paris (FR)**

(72) Inventeurs:
- **Larat, Christian, Thomson-CSF**
  **94117 Arcueil cedex (FR)**
- **Pocholle, Jean-Paul, Thomson-CSF**
  **94117 Arcueil cedex (FR)**

(54) **Dispositif de mise en forme d'un faisceau plat**

(57)    Dispositif de mise en forme d'un faisceau plat comportant :

- des moyens d'émission lumineux (S) émettant un faisceau lumineux plat délimité par deux faces planes ;
- une lame à faces principales parallèles (l) transparente à la longueur d'onde du faisceau ;
- des moyens d'entrée (P) transmettant le faisceau dans la lame de telle façon que la direction de propagation du faisceau dans la lame ne soit pas normale aux faces principales et que ces moyens définissent sur une face principale d'entrée une arête parallèle (B1-B2) au plan du faisceau ;
- des moyens de sortie (g") recevant le faisceau après une ou plusieurs réflexions internes dans la lame et définissant sur une face principale de sortie, une arête non parallèle au plan du faisceau dans la lame.

Application : Mise en forme d'un faisceau émis par une barrette laser.

FIG.2a

## Description

L'invention conceme un dispositif de mise en forme d'un faisceau plat et notamment d'un faisceau émis par une barrette de diodes lasers de puissance.

Les barrettes de diodes laser sont des assemblages monolithiques de diodes permettant de délivrer des puissances optiques élevées. Généralement de 1 cm de large dans la direction parallèle au plan de la jonction ($D_{//}$), leur surface émissive est d'environ 1 $\mu$m de haut dans la direction perpendiculaire ($D_{\perp}$). Une barrette est ainsi une source fortement dissymétrique, étant environ 10 000 fois plus large que haute. De même, la divergence du rayonnement est non symétrique : supérieure à 25° (30° à 50°) selon $D_{\perp}$, elle est d'environ 10° suivant $D_{//}$. La combinaison de ces deux caractéristiques conduit à une étendue géométrique environ 2 000 fois plus grande selon $D_{//}$ que selon $D_{\perp}$. Cette forte dissymétrie est tout à fait préjudiciable à l'emploi efficace de ces composants pour de nombreuses applications. En effet, outre la difficulté de manipulation, il est en général intéressant de disposer d'un faisceau d'étendue géométrique proche de la symétrie de révolution par exemple pour l'injection dans une fibre optique ou pour le pompage optique longitudinal de lasers solides.

L'invention a pour objet de résoudre ce problème en utilisant des optiques simples : telles qu'une lame à faces parallèles et éventuellement un prisme. L'intérêt d'un tel système est l'obtention d'une source image dont l'étendue géométrique est répartie plus uniformément selon les deux directions que la source initiale.

L'invention concerne donc un dispositif de mise en forme d'un faisceau plat, caractérisé en ce qu'il comporte:

- des moyens d'émission lumineux émettant un faisceau lumineux plat délimité par deux faces planes ;
- une lame à faces principales parallèles transparente à la longueur d'onde du faisceau ;
- des moyens d'entrée transmettant le faisceau dans la lame de telle façon que la direction de propagation du faisceau dans la lame ne soit pas normale aux faces principales et que ces moyens définissent sur une face principale d'entrée une arête parallèle au plan du faisceau ;
- des moyens de sortie recevant le faisceau après une ou plusieurs réflexions internes dans la lame et définissant sur une face principale de sortie, une arête non parallèle au plan du faisceau dans la lame.

Les différents objets et caractéristiques de l'invention apparaîtront plus clairement dans la description qui va suivre et dans les figures annexées qui représentent :

- les figures 1a et 1b, un exemple de réalisation du dispositif selon l'invention ;
- les figures 2a à 2c, le fonctionnement du dispositif de l'invention ;
- la figure 3, la trace des faisceaux de sortie sur la face de sortie de la lame à face parallèle ;
- les figures 4, 5 et 6, des variantes de réalisation de l'invention.

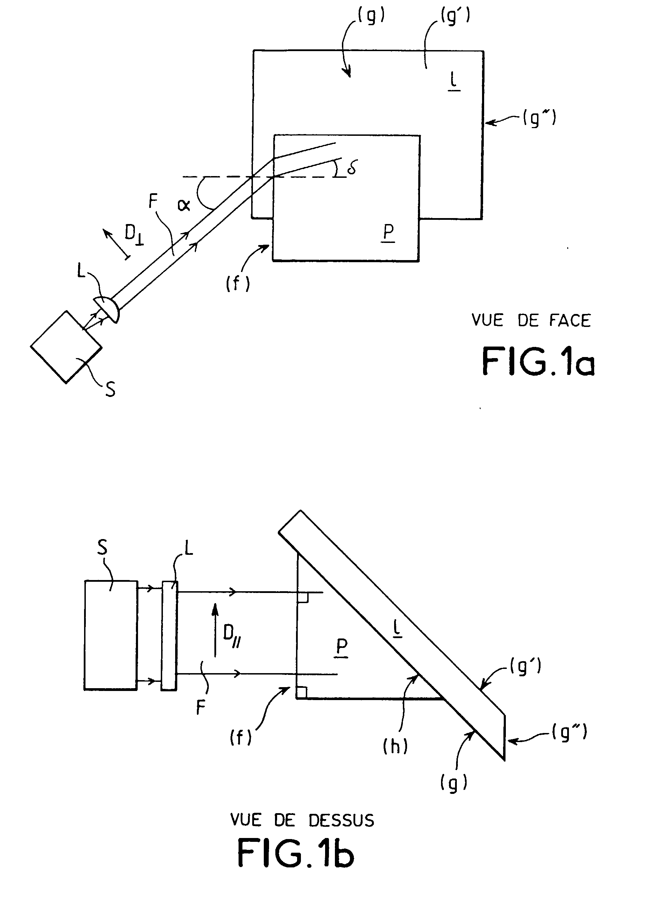

Le dispositif de l'invention représenté en figures 1a et 1b comporte une source lumineuse S émettant un faisceau lumineux dont la section est de forme sensiblement rectangulaire dont l'épaisseur $t_o$ est nettement inférieure à la largeur b. Ce faisceau est transmis à un prisme p auquel est accolée une lame à faces parallèles l.

Le faisceau émis par la source peut présenter une grande divergence dans la direction $D_{\perp}$ (perpendiculaire au plan d'épitaxie). Cette divergence peut alors être réduite par une lentille cylindrique L à une valeur de quelques degrés ou moins. La lentille L a, par exemple, un diamètre de 0,1 à 1 mm environ. On peut utiliser par exemple une fibre optique classique ou une lentille corrigée des aberrations. L'autre direction $D_{//}$ reste inchangée. Le faisceau F se présente alors sous la forme d'une "nappe" lumineuse beaucoup plus large (suivant $D_{//}$) que haute (suivant $D_{\perp}$).

Le faisceau F entre ensuite (figure 1) dans le prisme p (indice = n). La face h du prisme est collé avec une colle isoindice sur la face g d'une lame à faces parallèles l (épaisseur = e, indice = n). Pour exposer le principe du système de l'invention, on supposera que le faisceau lumineux est parfaitement collimaté, que le prisme est isocèle à angle droit et que le faisceau y entre par une de ses petites faces f.

Le faisceau fait un angle d'incidence $\alpha$ avec la face f du prisme, ce qui correspond à un angle $\delta$ à l'intérieur du prisme ($\sin \alpha = n \times \sin \delta$).

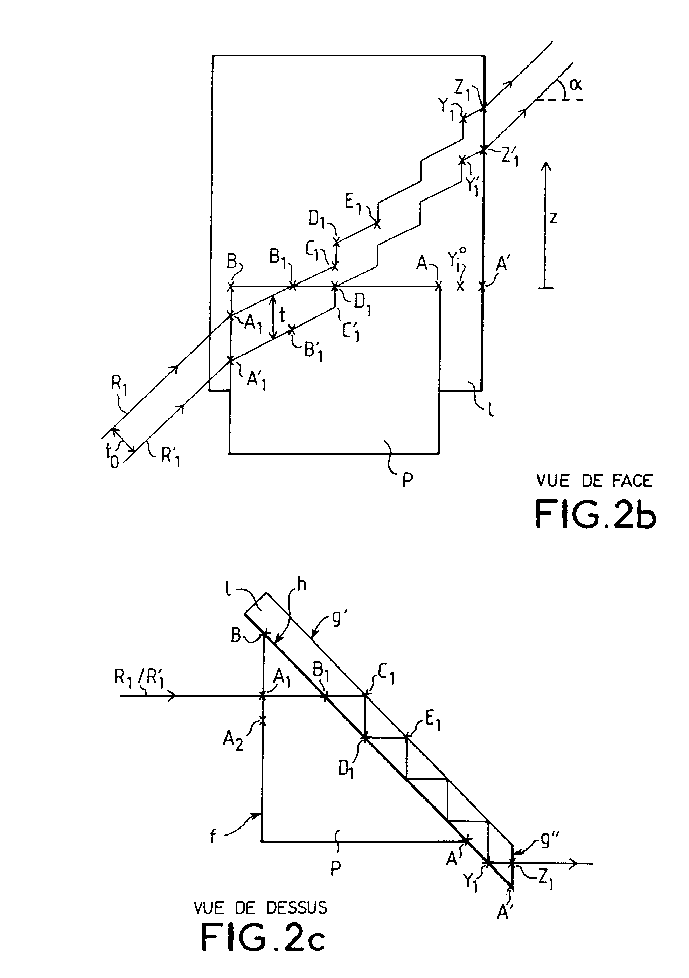

Soit un rayon $R_1$ (figure 2b), situé sur le dessus de la "nappe" lumineuse et qui intercepte la face f en $A_1$ et arrive sur la face h en $B_1$, juste au niveau de l'arête (A-B) du prisme (figure 2b). La position du faisceau lumineux est ajustée pour cela. Du fait de la colle isoindice entre les faces h du prisme p et g de la lame l, le rayon $R_1$ passe sans déflexion ni pertes directement dans la lame l et subit une Réflexion Totale Interne (RTI) sur la face g' en $C_1$. Du fait de l'angle $\delta$, le rayon $R_1$ est désormais piégé dans la lame l et subit des réflexions totales internes en $D_1$, $E_1$, ... jusqu'à son arrivée en $Z_1$ sur la face g" qui est inclinée par exemple à 45° par rapport à g et g'. Le rayon $R_1$ sort dans ce cas de la lame l sous l'angle $\alpha$.

Soit un rayon $R'_1$ situé sur le dessous de la "nappe" lumineuse (figure 2b) et qui intercepte la face en $A'_1$ et arrive sur la face h en $B'_1$, à une hauteur t sous l'arête (A-B) du prisme. Comme pour le rayon $R_1$, le rayon $R'_1$ passe sans

déflexion ni pertes directement dans la lame I et subisse une réflexion totale interne sur la face g" en C'$_1$.

Pour que le rayon R'$_1$ soit également piégé dans la lame I et subisse des réflexions totales en D'$_1$ et ainsi de suite, t et $\delta$ doivent vérifier la relation $t \leq 2\sqrt{2}\sqrt{2} \times e \times tg(\delta)$. Après avoir subi le même nombre de réflexions que le rayon R$_1$, le rayon R'$_1$ sort de la lame I par la face g" en Z'$_1$ qui se trouve à t en dessous de Z$_1$.

Soit un rayon R$_2$ situé comme R$_1$ sur le dessus de la "nappe" lumineuse et qui intercepte f en A$_2$. Par une rotation appropriée autour du rayon R$_1$ précédent, R$_2$ arrive sur la face h en B$_2$, juste au niveau de l'arête (A-B) du prisme. La "nappe" lumineuse est ainsi tangente à l'arête (A-B) et se trouve de fait inclinée d'un angle $\beta$ par rapport au plan de la vue de dessus de la figure 1. Comme pour le rayon R$_1$, R$_2$ passe ensuite par les points C$_2$, D$_2$, ...jusqu'à sa sortie en Z$_2$ sur la face g" de la lame I. De façon similaire au rayon R'$_1$, le rayon R'$_2$ situé en dessous du rayon R$_2$ ressortira en Z'$_2$ sous Z$_2$.

Le nombre N de réflexions totales internes subies par le rayon R$_1$ dépend de la distance A'B$_1$ (figure 2b). On a ainsi : $N = 2 \times E[(A'B_1)/(2e)]$ où E[x] représente la partie entière de x. La côte z du point Z$_1$ est alors égale à :

$$z = \left[(Y_1{}^\circ B_1) \times \sqrt{2} + \frac{(A'Y_1{}^\circ)}{\sqrt{2}}\right] \times tg(\delta)$$

$$= \left[N \times e \times \sqrt{2} + \frac{(A'B_1) - N \times e}{\sqrt{2}}\right] \times tg(\delta)$$

$$= \left[N \times e + (A'B_1)\right] \times \frac{tg(\delta)}{\sqrt{2}}$$

La "nappe" lumineuse se trouve ainsi transformée en une superposition de "bandelettes" inclinées de l'angle $\delta$.

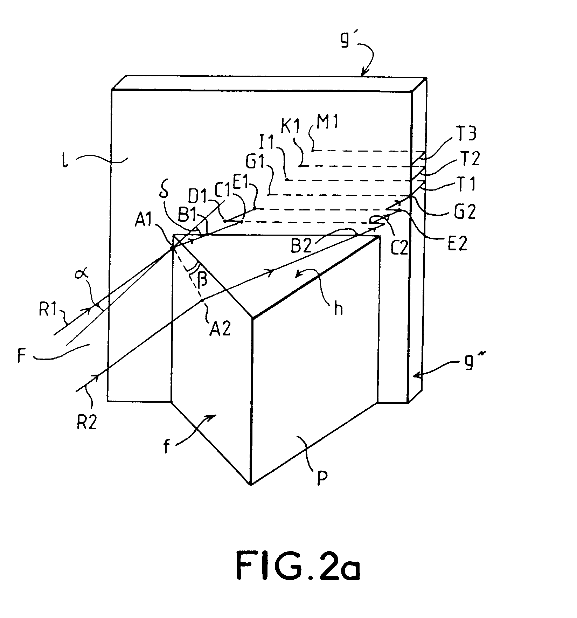

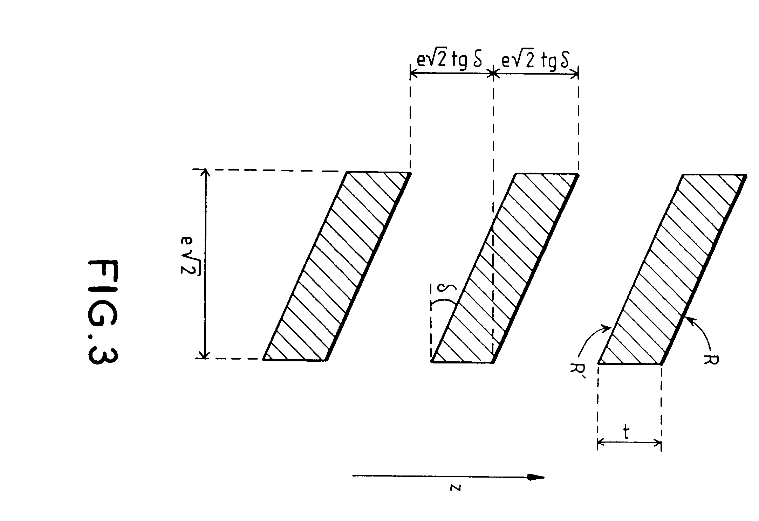

La figure 2a représente le mécanisme de réflexion de la face supérieure du faisceau F et matérialisé sur cette figure par les rayons R$_1$ et R$_2$. Cette face du faisceau fait un angle a avec la normale à la face f du prisme et sa trace sur la face f fait un angle $\beta$ avec la section droite du prisme. Ainsi les rayons R$_1$, R$_2$ passent par deux points B$_1$, B$_2$ situés sur l'arête du prisme commune avec la lame I. Ces rayons subissent, comme décrit précédemment, une série de réflexions totales internes dans la lame I. Pour simplifier, on a représenté que les traces des réflexions C1-C2, E1-E2, G1-G2 sur la face g' de la lame. Après ces réflexions, le faisceau atteint la face latérale g" de la lame. On voit alors que le faisceau est découpé en bandelettes lumineuses T1, T2, T3. La figure 3 représente ainsi la transformation de la nappe lumineuse du faisceau F en un empilement de bandelettes lumineuse.

Pour que les "bandelettes" se touchent, il faut que "l'épaisseur" t de la "nappe" lumineuse vérifie :

$$t = 4 \times e \times \frac{tg(\delta)}{\sqrt{2}} = 2\sqrt{2} \times e \times tg(\delta)$$

ce qui correspond à la valeur limite définie précédemment. Dans ces conditions, la section de la "nappe" lumineuse a été transformée à surface constante. On peut ainsi modifier le rapport hauteur/largeur du faisceau en ajustant soit e, soit $\delta$ (on suppose la valeur de t donnée et e et $\delta$ vérifient la relation précédente). On réalise ainsi un "empilement optique" du faisceau lumineux : il est découpé en morceaux qui sont ensuite placés les uns sous les autres.

Le fait que le faisceau ne soit pas parfaitement collimaté ne modifie pas le principe exposé précédemment, à condition que l'incidence des faisceaux sur les faces g et g' de la lame I reste en réflexion totale. Ce sont les limites calculées précédemment qui sont modifiées pour tenir compte des divergences selon D$_{//}$ et D$_\perp$. Par exemple, "l'épaisseur" t de la "nappe" lumineuse n'est plus forcément constante au niveau de l'arête (A-B). Les divergences en sortie de la lame I restent les mêmes qu'en entrée $\theta_{//}$ et $\theta_\perp$.

Pour répartir l'étendue géométrique de la barrette uniformément selon les deux directions, il suffit de modifier la section du faisceau pour que le produit largeur du faisceau par la divergence $\theta_{//}$ en sortie soit égal au produit hauteur du faisceau par la divergence $\theta_\perp$. Même si le faisceau en sortie du système a une étendue géométrique parfaitement de symétrie de révolution, il n'est pas forcément symétrique en dimension (et donc également en divergence). Cela peut être corrigé par exemple par l'emploi de deux lentilles cylindriques qui imageront la barrette transformée avec des grandissements différents, compensant ainsi la différence de taille sans modifier l'étendue géométrique.

L'invention a été décrite en se reportant au mode de réalisation des figures 1a, 1b et 2a à 2c.

D'autres variantes telles que les suivantes peuvent être envisagées :

- Le dispositif de l'invention a été décrit avec un angle d'incidence du faisceau sur la lame dans le plan horizontal de 45° (figure 1b) mais tout angle est a priori possible à condition que les faisceaux restent en réflexion totale sur les faces g et g' de la lame l.
- La forme du prisme p peut être modifiée, le seul point important étant en fait que la "nappe" lumineuse soit tangente à l'arête (A-B). Par exemple, on peut s'arranger pour que le faisceau soit à incidence normale sur la face d'entrée f du prisme.
- De la même façon, la face de sortie g" de la lame l peut être inclinée sous un angle autre que 45° et/ou pivotée dans le plan de la lame. Cela peut permettre notamment d'obtenir un empilement parfaitement aligné verticalement.
- Le prisme p peut être remplacé par une lamelle d'épaisseur constante t et inclinée de $\delta$ (voir lamelle G sur la figure 5). En plus du rôle du prisme précédent, elle impose à la "nappe" lumineuse une épaisseur constante malgré la divergence verticale ($\theta_\perp$).
- La source lumineuse (barrette de diodes + lentille de collimation) peut être imagée par une ou plusieurs lentilles entre l'arête (A-B) et la face de sortie du système g". L'image est une succession de taches, images des diodes élémentaires (ou des réseaux de diodes élémentaires) constitutives de la barrette. En effet, le facteur de remplissage d'une barrette n'est pas de 1 (pour une barrette continue, il est en général inférieur à 0,5). Cette imagerie peut présenter deux avantages. On peut ainsi s'arranger pour que la zone où le faisceau est découpé par les bords de la face de sortie g" de la lame l correspondent à des zones sombres, limitant ainsi les pertes par diffraction à ce niveau. De plus, on minimise aussi l'éventuelle courbure de la "nappe" lumineuse consécutive à une légère courbure de la barrette de diodes et/ou de la lentille de collimation ("smile problem").
- Les faisceaux de deux assemblages barrette/système optique, peuvent être superposés par multiplexage de polarisation.
- Les faces d'entrée/sortie du système optique peuvent être traitées antireflet pour minimiser les pertes.
- On peut s'affranchir de la réflexion totale interne sur les faces de la lame (l) en prévoyant, sur ces faces, des dépôts réfléchissants (métalliques, diélectriques, ...).
- Le système optique peut être réalisé monolithiquement par micro-usinage, moulage, polissage.
- Il est possible d'utiliser non pas une barrette simple mais un empilement de barrettes, chacune étant collimatée individuellement. Cela revient à considérer une "nappe" lumineuse de plus grande épaisseur.

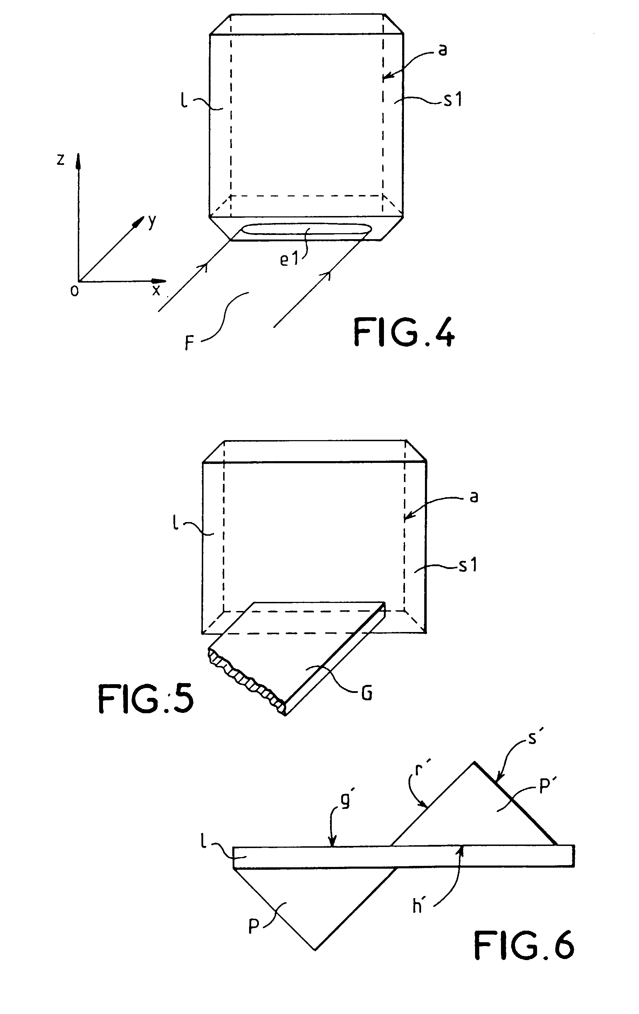

La figure 4 représente une variante selon laquelle le dispositif de l'invention est simplement constitué d'une lame à faces parallèles l possédant une face d'entrée el et une face de sortie convenablement taillée. Sur la figure 4, la lame l est représentée dans un trièdre de référence xyz. La face el n'est parallèle à aucun des plans de référence du trièdre ; elle n'est pas perpendiculaire aux faces principales de la lame de telle façon qu'un faisceau plat F pénètre par cette face dans la lame et subisse des réflexions totales internes. On retrouve alors le fonctionnement précédent. Le faisceau étant convenablement incliné, il atteint ensuite la face de sortie s1 après plusieurs réflexions internes. C'est l'arête "a" située à la jonction de la tranche s1 (face de sortie) et de la face arrière de la lame qui réalise la découpe du faisceau en lamelles.

La figure 6 est une variante directe du dispositif des figures la à 2c. Selon cette variante, on prévoit un prisme de sortie P' accolé à la face g' et permettant la sortie du faisceau. Ce prisme peut être conçu et positionné pour que la structure ait un fonctionnement symétrique.

On peut également avoir une variante combinant les figures 4 et 6 dans laquelle la lame l comporte une face d'entrée el et un prisme de sortie P'. Cette variante est une disposition symétrique de celle des figures la et 1b.

De même, dans la description qui précède, on a considéré des faces (ou des dispositifs) d'entrée et de sortie, mais le système de l'invention peut fonctionner de manière symétrique, les moyens de sortie devenant les moyens d'entrée et réciproquement.

**Revendications**

1. Dispositif de mise en forme d'un faisceau plat, caractérisé en ce qu'il comporte :

   - des moyens d'émission lumineux (S) émettant un faisceau lumineux plat délimité par deux faces planes ;
   - une lame à faces principales parallèles (l) transparente à la longueur d'onde du faisceau ;
   - des moyens d'entrée transmettant le faisceau dans la lame de telle façon que la direction de propagation du faisceau dans la lame ne soit pas normale aux faces principales et que ces moyens définissent sur une face principale d'entrée une arête parallèle au plan du faisceau ;
   - des moyens de sortie recevant le faisceau après une ou plusieurs réflexions internes dans la lame et définissant sur une face principale de sortie, une arête non parallèle au plan du faisceau dans la lame.

**2.** Dispositif selon la revendication 1, caractérisé en ce que la lame à faces parallèles comporte une tranche d'entrée (e1) faisant un angle non nul avec la face principale d'entrée et recevant le faisceau selon un angle permettant l'entrée du faisceau dans la lame, l'arête entre la lame et la face principale d'entrée définissant ladite arête des moyens d'entrée.

**3.** Dispositif selon la revendication 1, caractérisé en ce que les moyens d'entrée comportent :

- un prisme (p) transparent à la longueur d'onde du faisceau lumineux comprenant au moins une première face (f) et une deuxième face (h) du prisme et une face d'extrémité (r), la deuxième face étant accolée à la face principale de la lame ;

le faisceau étant incident sur la première face du prisme de telle façon que le faisceau atteigne la lame à faces parallèles dans une zone qui est parallèle à l'intersection de la lame et de la face d'extrémité (r) du prisme, laquelle intersection est ladite arête des moyens d'entrée.

**4.** Dispositif selon la revendication 3, caractérisé en ce que les moyens d'entrée comportent un guide optique en un matériau de guidage d'indice adapté à l'indice de la lame à faces parallèles.

**5.** Dispositif selon la revendication 1, caractérisé en ce que la lame à faces parallèles comporte une tranche de sortie (s1) dont l'orientation définit avec la face principale de sortie ladite arête des moyens de sortie.

**6.** Dispositif selon la revendication 1, caractérisé en ce que les moyens de sortie comportent :

- un prisme (P') transparent à la longueur d'onde du faisceau lumineux, comportant au moins une première face (h'), une deuxième face (s') et une face d'extrémité (r'), la première face (h') étant accolée à la face principale de sortie de la lame, et la face d'extrémité (r') définissant avec la face principale de sortie ladite arête des moyens de sortie.

**7.** Dispositif selon l'une des revendications 2 à 6, caractérisé en ce que les faces principales d'entrée et de sortie sont la même face ou sont les deux faces principales de la lame (l).

**8.** Dispositif selon les revendications 3, 4 ou 6, caractérisé en ce que le ou les prismes et la lame à faces parallèles sont de même indices de réfraction et qu'ils sont collés à l'aide d'une colle isoindice.

**9.** Dispositif selon l'une des revendications 1 à 3, caractérisé en ce que l'épaisseur du faisceau et l'épaisseur de la lame (l) sont liées de telle façon que si le haut du faisceau est tangent à ladite arête des moyens d'entrée, le bas du faisceau après réflexion sur la face principale de la lame opposée à la face principale d'entrée se réfléchit ensuite sur la face principale d'entrée dans une zone de la face principale d'entrée ne possédant pas de moyens d'entrée.

**10.** Dispositif selon la revendication 3 ou 6, caractérisé en ce que le prisme (p) est un prisme rectangle isocèle.

**11.** Dispositif selon l'une des revendications 1, 5 ou 6, caractérisé en ce que ladite arête est contenue dans un plan parallèle :

- à la direction de propagation du faisceau dans la lame ;
- et à la normale aux faces planes du faisceau dans la lame.

VUE DE FACE

# FIG.1a

VUE DE DESSUS

# FIG.1b

# FIG.2a

VUE DE FACE
# FIG.2b

VUE DE DESSUS
# FIG.2c

FIG.3

FIG.4

FIG.5

FIG.6

# EP 0 805 368 A1

<table>
<tr><td colspan="2">Office européen<br>des brevets</td><td>**RAPPORT DE RECHERCHE EUROPEENNE**</td><td>Numero de la demande<br><br>EP 97 40 0957</td></tr>
</table>

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | WO 95 15510 A (UNIVERSITY OF SOUTHAMPTON)<br>* abrégé; figures 1-8 *<br>--- | 1 | G02B27/09<br>H01S3/25 |
| A | EP 0 525 528 A (C.ZEISS)<br>* page 3; figure 3 *<br>----- | 1 | |

DOMAINES TECHNIQUES
RECHERCHES (Int.Cl.6)

G02B
H01S

Le présent rapport a été établi pour toutes les revendications

| Lieu de la recherche | Date d'achèvement de la recherche | Examinateur |
|---|---|---|
| LA HAYE | 27 Juin 1997 | Malic, K |

**CATEGORIE DES DOCUMENTS CITES**

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
........................................................................
& : membre de la même famille, document correspondant

EPO FORM 1503 03.82 (P04C02)